(19) **Europäisches Patentamt / European Patent Office / Office européen des brevets**

(11) **EP 4 254 486 A1**

(12) # EUROPEAN PATENT APPLICATION
published in accordance with Art. 153(4) EPC

(43) Date of publication:
04.10.2023 Bulletin 2023/40

(21) Application number: 21898040.7

(22) Date of filing: 25.11.2021

(51) International Patent Classification (IPC):
*H01L 23/36* (2006.01)

(52) Cooperative Patent Classification (CPC):
H01L 23/36

(86) International application number:
PCT/JP2021/043225

(87) International publication number:
WO 2022/114068 (02.06.2022 Gazette 2022/22)

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
KH MA MD TN

(30) Priority: 25.11.2020 JP 2020195064

(71) Applicant: Mitsubishi Materials Corporation
Tokyo 100-8117 (JP)

(72) Inventors:
• SAKANIWA, Yoshiaki
Saitama-shi, Saitama 330-8508 (JP)
• OHASHI, Toyo
Saitama-shi, Saitama 330-8508 (JP)
• SAKAMAKI, Marina
Saitama-shi, Saitama 330-8508 (JP)
• KUBOTA, Kenji
Naka-shi, Ibaraki 311-0102 (JP)

(74) Representative: Hoffmann Eitle
Patent- und Rechtsanwälte PartmbB
Arabellastraße 30
81925 München (DE)

(54) **HEATSINK-INTEGRATED INSULATING CIRCUIT BOARD AND METHOD FOR MANUFACTURING HEATSINK-INTEGRATED INSULATING CIRCUIT BOARD**

(57) A heatsink-integrated insulating circuit board includes a heat sink (20) including a radiating fin (22), an insulating resin layer (12) formed on a top plate part (21) of the heat sink (20), and a circuit layer (13) arranged on one surface of the insulating resin layer (12). An angle θ formed between an end of the metal piece (33) and a surface of the insulating resin layer (12) is set to be 70° or more and 110° or less. Root-mean-square heights Sq1 and Rq1 in bonding surfaces to the insulating resin layer (12) in the top plate part (21) of the heat sink (20) and the metal piece (33), and root-mean-square heights Sq2 and Rq1 in regions other than the bonding surfaces to the insulating resin layer (12) in the top plate part (21) of the heat sink (20) and the metal piece (33) have a relationship of Sq1 > Sq2 or Rq1 > Rq2.

FIG. 1

EP 4 254 486 A1

## Description

[Technical Field]

The present invention relates to a heatsink-integrated insulating circuit board and a method for manufacturing the heatsink-integrated insulating circuit board that includes a heat sink including a radiating fin, an insulating resin layer formed on a top plate part of the heat sink, and a circuit layer made of metal pieces arranged in a circuit pattern on one surface of the insulating resin layer.

Priority is claimed on Japanese Patent Application No. 2020-195064, filed November 25, 2020, the content of which is incorporated herein by reference.

[Background Art]

A power module, an LED module, and a thermoelectric module have a structure in which a power semiconductor element, an LED element, and a thermoelectric element are bonded to an insulating circuit board in which a circuit layer made of a conductive material formed on one surface of an insulating layer.

As the insulating circuit board described above, for example, a metal-based circuit board disclosed in Patent Document 1 has been proposed. Further, Patent Document 2 proposes a multilayer wiring board.

In the metal-based circuit board disclosed in Patent Document 1, an insulating resin layer is formed on a metal substrate, and a circuit layer having a circuit pattern is formed on the insulating resin layer. Here, the insulating resin layer is made of an epoxy resin that is a thermosetting resin, and the circuit layer is made of a copper foil.

Such a metal-based circuit board has a structure in which a semiconductor element is bonded onto the circuit layer, and a heat sink is arranged on the surface of the metal substrate on the opposite side of the insulating resin layer, and thus heat generated by the semiconductor element is transmitted to the heat sink side to be radiated.

In the metal-based circuit board disclosed in Patent Document 1, a circuit pattern is formed by etching the copper foil arranged on the insulating resin layer.

In addition, in the multilayer wiring board disclosed in Patent Document 2, the surface roughness (Ra) of a metal foil adhered to a resin film is made to be 0.2 $\mu$m or more by etching the metal foil, and a wiring circuit layer is formed by further etching the metal foil in a circuit pattern. The wiring circuit layer formed on the surface of the resin film is buried in the surface of a soft insulating sheet while applying pressure, and an insulating circuit layer is transferred onto the surface of the insulating sheet. The multilayer wiring board is manufactured by laminating a plurality of insulating sheets obtained in this manner and collectively heat-curing the laminated plurality of insulating sheets.

[Citation List]

[Patent Documents]

[Patent Document 1]
Japanese Unexamined Patent Application, First Publication No. 2015-207666
[Patent Document 2]
Japanese Unexamined Patent Application, First Publication No. H09-135057

[Summary of Invention]

[Technical Problem]

In the recent years, there is a tendency that a current flowing through the semiconductor element mounted on the circuit layer is increasing, and accordingly, the amount of heat generated from the semiconductor element is also increasing. Therefore, in order to secure electrical conductivity and thermal conductivity, it is required to thicken the circuit layer.

Here, in a case where the circuit layer is thickened, when the circuit pattern is formed by performing etching as disclosed in Patent Documents 1 and 2, sagging occurs on the end surface of the circuit layer, and an electric field concentrates on the end surface of the circuit layer. Thus, there is a concern that the insulating property deteriorates.

Therefore, as a method for forming a circuit layer without performing etching, it is conceivable to bond a punched metal piece having a desired shape in advance to an insulating resin layer. According to this method, even when the circuit layer is thickened, it is possible to secure the insulating property between circuit patterns without an occurrence of sagging on the end surface of the metal piece, and it is also possible to reduce the distance between the circuit patterns.

Further, when the insulating resin layer and the circuit layer are bonded to each other, by roughening the surface of the circuit layer to increase the surface roughness of the bonding surface, it is possible to improve the bonding reliability between the insulating resin layer and the circuit layer.

Here, in a heatsink-integrated insulating circuit board in which the above-described insulating resin layer is formed on the top plate part of a heat sink including the radiating fin, and a circuit layer is arranged on the surface of the insulating resin layer on the opposite side of the heat sink, preferably, the surface of the circuit layer and the surface of the heat sink are roughened, and the heat sink, the insulating resin layer, and the circuit layer are bonded to each other.

Meanwhile, when roughening is also performed on a region other than the bonding surface to the insulating resin layer in the circuit layer and the top plate part of the heat sink, there is a concern that it is not possible to favorably form a plating layer during the subsequent plating.

In addition, when the surface of the circuit layer is roughened, there is a concern that it is not possible to favorably perform soldering and wire bonding. Also, the current flows on the surface of the circuit layer due to the skin effect when a highfrequency current flows through the circuit layer, but the roughening may cause an increase in resistance.

It is conceivable to perform masking during roughening so that the region other than the bonding surface to the insulating resin layer in the circuit layer and the top plate part of the heat sink is not roughened. However, it is very difficult to mask the region other than the bonding surface in a heat sink including a radiating fin.

The present invention has been made in view of the above-described circumstances, and an objective of the present invention is to provide a heatsink-integrated insulating circuit board and a method for manufacturing the heatsink-integrated insulating circuit board that is excellent in bonding reliability and insulating property between a circuit layer and the heat sink, and the insulating resin layer, is capable of favorably performing soldering, wire-bonding, and plating on the circuit layer and the heat sink, and is capable of being stably manufactured at low cost.

[Solution to Problem]

In order to solve the above-described problems, a heatsink-integrated insulating circuit board according to an aspect of the present invention (referred to as a "heatsink-integrated insulating circuit board according to the present invention" below) includes a heat sink including a radiating fin, an insulating resin layer formed on a top plate part of the heat sink, and a circuit layer made of metal pieces arranged in a circuit pattern on one surface of the insulating resin layer. An angle $\theta$ formed between an end of the metal piece and a surface of the insulating resin layer is in a range of 70° or more and 110° or less. When a root-mean-square height of a contour curved surface in a bonding surface of the top plate part of the heat sink to the insulating resin layer and a bonding surface of the metal piece to the insulating resin layer is set as Sq1, a root-mean-square height of a contour curved surface in a region of the top plate part of the heat sink other than the bonding surface to the insulating resin layer and a region of the metal piece other than the bonding surface to the insulating resin layer is set as Sq2, a root-mean-square height of a contour curve in the bonding surface of the top plate part of the heat sink to the insulating resin layer and the bonding surface of the metal piece to the insulating resin layer is set as Rq1, and a root-mean-square height of a contour curve in the region of the top plate part of the heat sink other than the bonding surface to the insulating resin layer and the region of the metal piece other than the bonding surface to the insulating resin layer is set as Rq2, a relationship of Sq1 > Sq2 or Rq1 > Rq2 is satisfied.

According to the heatsink-integrated insulating circuit board having such a configuration, the angle $\theta$ formed between the end of the metal piece and the surface of the insulating resin layer is set to be in the range of 70° or more and 110° or less, and thus there is no sagging in the end surface of the circuit layer. It is possible to suppress electric field concentration on the end surface of the circuit layer, and the insulating property is excellent.

Then, since the root-mean-square height Sq1 of the contour curved surface in the bonding surface of the top plate part of the heat sink to the insulating resin layer and the bonding surface of the metal piece to the insulating resin layer is more than the root-mean-square height Sq2 of the contour curved surface in the region of the top plate part of the heat sink other than the bonding surface to the insulating resin layer and the region of the metal piece other than the bonding surface to the insulating resin layer, or the root-mean-square height Rq1 of the contour curve in the bonding surface of the top plate part of the heat sink to the insulating resin layer and the bonding surface of the metal piece to the insulating resin layer is more than the root-mean-square height Rq2 of the contour curve in the region of the top plate part of the heat sink other than the bonding surface to the insulating resin layer and the region of the metal piece other than the bonding surface to the insulating resin layer, and the bonding surface is set to be rougher than the region other than the bonding surface, bonding reliability between the metal piece and the insulating resin layer and between the insulating resin layer and the top plate part of the heat sink is excellent, the surface other than the bonding surface is not rough, and platability, solderability, and wire-bondability are excellent.

Here, in the heatsink-integrated insulating circuit board according to the present invention, a ratio Sq1/Sq2 between the root-mean-square height Sq1 of the contour curved surface in the bonding surface and the root-mean-square height Sq2 of the contour curved surface in the region other than the bonding surface, or a ratio Rq1/Rq2 between the root-mean-square height Rq1 of the contour curve in the bonding surface and the root-mean-square height Rq2 of the contour curve in the region other than the bonding surface is preferably set to be in a range of 1.1 or more and 5.0 or less.

In this case, since the ratio Sq1/Sq2 between the root-mean-square height Sq1 of the contour curved surface in the bonding surface and the root-mean-square height Sq2 of the contour curved surface in the region other than the bonding surface, or the ratio Rq1/Rq2 between the root-mean-square height Rq1 of the contour curve in the bonding surface and the root-mean-square height Rq2 of the contour curve in the region other than the bonding surface is set to be 1.1 or more, the root-mean-square height Sq1 of the contour curved surface in the bonding surface or the root-mean-square height Rq1 of the contour curve in the bonding surface is sufficiently large, and the bonding reliability between the metal piece and the insulating resin layer and between the insulating resin layer and the top plate part of the heat sink is excellent.

In addition, the root-mean-square height Sq2 of the contour curved surface in the region other than the bonding surface or the root-mean-square height Rq2 of the contour curve in the region other than the bonding surface is sufficiently small, and the platability, solderability, and wire-bondability are excellent.

On the other hand, since the ratio Sq1/Sq2 between the root-mean-square height Sq1 of the contour curved surface in the bonding surface and the root-mean-square height Sq2 of the contour curved surface in the region other than the bonding surface, or the ratio Rq1/Rq2 between the root-mean-square height Rq1 of the contour curve in the bonding surface and the root-mean-square height Rq2 of the contour curve in the region other than the bonding surface is set to be 5.0 or less, the root-mean-square height Sq1 of the contour curved surface in the bonding surface is not largely different from the root-mean-square height Sq2 of the contour curved surface in the region other than the bonding surface, or the root-mean-square height Rq1 of the contour curve in the bonding surface is not largely different from the root-mean-square height Rq2 of the contour curve in the region other than the bonding surface, and it is possible to manufacture the heatsink-integrated insulating circuit board at relatively low cost.

Further, in the heatsink-integrated insulating circuit board according to the present invention, the root-mean-square height Sq1 of the contour curved surface in the bonding surface or the root-mean-square height Rq1 of the contour curve in the bonding surface is preferably set to be in a range of 0.45 $\mu$m or more and 1.0 $\mu$m or less.

In this case, since the root-mean-square height Sq1 of the contour curved surface in the bonding surface or the root-mean-square height Rq1 of the contour curve in the bonding surface is sufficiently large, the bonding reliability between the metal piece and the insulating resin layer, and between the insulating resin layer and the top plate part of the heat sink is excellent.

Further, in the heatsink-integrated insulating circuit board according to the present invention, the root-mean-square height Sq2 of the contour curved surface in the region other than the bonding surface or the root-mean-square height Rq2 of the contour curve in the region other than the bonding surface is preferably set to be in a range of 0.1 $\mu$m or more and 0.4 $\mu$m or less.

In this case, since the root-mean-square height Sq2 of the contour curved surface in the region other than the bonding surface or the root-mean-square height Rq2 of the contour curve in the region other than the bonding surface is sufficiently small, the platability, solderability, and wire-bondability are excellent.

A method for manufacturing a heatsink-integrated insulating circuit board according to another aspect of the present invention (referred to as a "method for manufacturing a heatsink-integrated insulating circuit board according to the present invention" below) is a method for manufacturing a heatsink-integrated insulating circuit board including a heat sink including a radiating fin, an insulating resin layer formed on a top plate part of the heat sink, and a circuit layer made of metal pieces arranged in a circuit pattern on one surface of the insulating resin layer. The method includes a surface roughening step of roughening a surface of the heat sink and a surface of the metal piece, a resin composition arrangement step of arranging a resin composition made of a thermosetting resin on the top plate part of the heat sink subjected to the surface roughening step, a metal piece disposition step of disposing the metal piece in a circuit pattern on the resin composition, a pressurization and heating step of pressurizing and heating the heat sink, the resin composition, and the metal piece in at least a laminating direction to cure the resin composition and form the insulating resin layer and to bond the insulating resin layer and the metal piece to each other and bond the insulating resin layer and the heat sink to each other, and a chemical polishing step of chemically polishing the surfaces of the heat sink and the metal piece after the pressurization and heating step.

According to the method for manufacturing a heatsink-integrated insulating circuit board according to the present invention, the surface roughening step of roughening the surfaces of the heat sink and the metal piece is performed, and then the resin composition arrangement step, the metal piece disposition step, and the pressurization and heating step are performed. Thus, the root-mean-square height Sq1 of the contour curved surface or the root-mean-square height Rq1 of the contour curve in the bonding surface of the circuit layer and the top plate part of the heat sink to the insulating resin layer is sufficiently large, and it is possible to manufacture a heatsink-integrated insulating circuit board having excellent bonding reliability between the metal piece and the heat sink, and the insulating resin layer.

Since the chemical polishing step of chemically polishing the surfaces of the heat sink and the metal piece is provided after the pressurization and heating step, the root-mean-square height Sq2 of the contour curved surface or the root-mean-square height Rq2 of the contour curve in the region of the circuit layer and the top plate part of the heat sink other than the bonding surface to the insulating resin layer is sufficiently small, and it is possible to manufacture a heatsink-integrated insulating circuit board that is excellent in platability, solderability, and wire-bondability.

[Advantageous Effects of Invention]

According to the present invention, it is possible to provide a heatsink-integrated insulating circuit board and a method for manufacturing the heatsink-integrated insulating circuit board in which the bonding reliability and the insulating property between the circuit layer and the heat sink, and the insulating resin layer are excellent, and it is possible to favorably perform soldering, wire-bonding, and plating on the circuit layer and the heat sink, and which can be stably manufactured at low cost.

[Brief Description of Drawings]

FIG. 1 is a cross-sectional schematic diagram of a power module using a heatsink-integrated insulating circuit board according to an embodiment of the present invention.
FIG. 2 is an enlarged diagram of a bonding interface between a circuit layer (metal piece) and an insulating resin layer in the heatsink-integrated insulating circuit board represented in FIG. 1.
FIG. 3 is a flowchart representing an example of a method for manufacturing the heatsink-integrated insulating circuit board according to the embodiment of the present invention.
FIG. 4 is a schematic diagram representing an example of the method for manufacturing the heatsink-integrated insulating circuit board according to the embodiment of the present invention.
FIG. 5 is a schematic diagram representing the example of the method for manufacturing the heatsink-integrated insulating circuit board according to the embodiment of the present invention.
FIG. 6 is a schematic diagram of a test device that evaluates a withstand voltage property of an insulating circuit board in an example.

[Description of Embodiments]

Hereinafter, an embodiment of the present invention will be described with reference to the accompanying drawings.

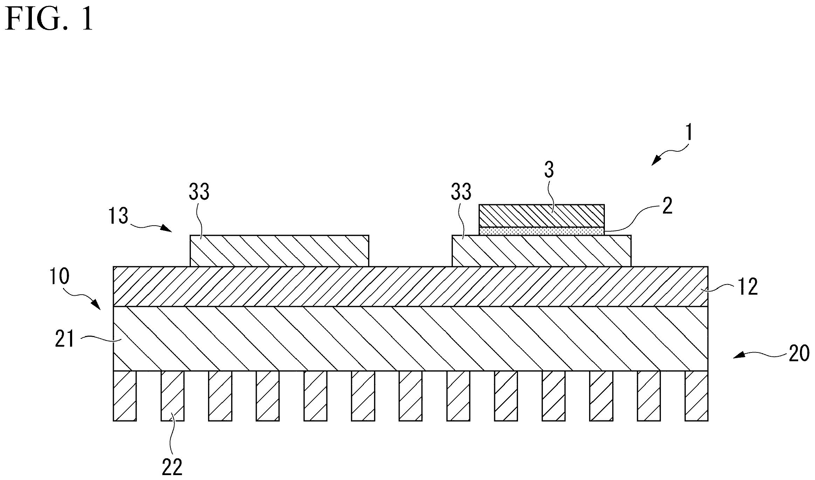

FIG. 1 represents a heatsink-integrated insulating circuit board 10 and a power module 1 using the heatsink-integrated insulating circuit board 10 according to an embodiment of the present invention.
The power module 1 includes the heatsink-integrated insulating circuit board 10 and a semiconductor element 3 bonded to one side (upper side in FIG. 1) of the heatsink-integrated insulating circuit board 10 via a solder layer 2.
The semiconductor element 3 is an electronic component including a semiconductor, and various semiconductor elements are selected in accordance with required functions.
The solder layer 2 that bonds the heatsink-integrated insulating circuit board 10 and the semiconductor element 3 to each other is made of, for example, a Sn-Ag-based, Sn-Cu-based, Sn-In-based, or Sn-Ag-Cu-based solder material (so-called a lead-free solder material).
The heatsink-integrated insulating circuit board 10 includes a heat sink 20, an insulating resin layer 12 formed on one surface (upper surface in FIG. 1) of a top plate part 21 of the heat sink 20, and a circuit layer 13 formed on one surface (upper surface in FIG. 1) of the insulating resin layer 12. The above-described semiconductor element 3 is bonded to one surface (upper surface in FIG. 1) of the circuit layer 13.
The heat sink 20 includes the top plate part 21 and a radiating fin 22 protruding from the other surface (lower surface in FIG. 1) of the top plate part 21.
The heat sink 20 has a configuration in which heat is spread in the top plate part 21 in a surface direction and is radiated to the outside via the radiating fin 22. Therefore, the heat sink 20 is made of metal having excellent thermal conductivity, for example, copper or a copper alloy, aluminum or an aluminum alloy. In the present embodiment, the heat sink is made of oxygen-free copper (OFC).
Here, it is preferable that the thickness of the top plate part 21 of the heat sink 20 is set within a range of 0.5 mm or more and 6.0 mm or less.
The heat sink 20 may have a structure in which the radiating fins 22 are pin fins, or have a structure in which the radiating fins 22 are formed in a comb shape. Further, it is preferable that a volume ratio occupied by the radiating fin 22 in a place where the radiating fin 22 is formed is within a range of 10% or more and 40% or less.

The insulating resin layer 12 prevents an electrical connection between the circuit layer 13 and the heat sink 20, and is made of an insulating resin.

In the present embodiment, it is preferable to use a resin containing a filler of an inorganic material in order to secure the strength of the insulating resin layer 12 and to secure the thermal conductivity. Here, as the filler, for example, alumina, boron nitride, aluminum nitride, or the like can be used. From the viewpoint of securing the thermal conductivity in the insulating resin layer 12, the content of the filler is preferably 50 mass% or more, and more preferably 70 mass% or more.

Further, as a thermosetting resin, for example, an epoxy resin, a polyimide resin, a silicon resin, or the like can be used. Here, if the thermosetting resin is an epoxy resin, the thermosetting resin can contain 80 mass % or more of the filler.

In order to sufficiently secure the insulating property of the insulating resin layer 12, the lower limit of the thickness of the insulating resin layer 12 is preferably set to 25 $\mu$m or more, and more preferably 50 $\mu$m or more. On the other hand, in order to further secure the heat radiation in the heatsink-integrated insulating circuit board 10, the upper limit of the thickness of the insulating resin layer 12 is preferably set to 300 $\mu$m or less, and more preferably 200 $\mu$m or less.

The thermal conductivity W/(m·K) of the insulating resin layer 12 is preferably 0.5 W/(m·K) or more and 20 W/(m·K) or less, and is more preferably 0.7 W/(m·K) or more and 18 W/(m·K) or less.

The dielectric breakdown voltage (kV/mm) of the insulating resin layer 12 is preferably 50 kV/nun or more and 65 kV/mm or less, and is more preferably 52 kV/mm or more and 62 kV/mm or less.

As represented in FIG. 1, the circuit layer 13 is formed by bonding a metal piece 33 made of metal having excellent electrical conductivity to one surface (upper surface in FIG. 1) of the insulating resin layer 12. As the metal piece 33, copper or a copper alloy, aluminum, an aluminum alloy, or the like can be used. In the present embodiment, as the metal piece 33 constituting the circuit layer 13, a metal piece obtained by punching out a rolled plate of oxygen-free copper is used.

In the circuit layer 13, a circuit pattern is formed by disposing the above-described metal pieces 33 in a circuit pattern, and one surface of the circuit layer 13 (upper surface in FIG. 1) serves as a mounting surface on which the semiconductor element 3 is mounted.

Here, the thickness of the circuit layer 13 (metal piece 33) is set to be 0.5 mm or more. The thickness of the circuit layer 13 (metal piece 33) is preferably 1.0 mm or more, and more preferably 1.5 mm or more. Further, the upper limit of the thickness of the circuit layer 13 (metal piece 33) is not particularly limited, but is practically set to be 3.0 mm or less.

The bonding surface between the circuit layer 13 and the semiconductor element 3 is evaluated using SAT (ultrasound imaging device, Fine SAT V manufactured by Hitachi Power Solutions), and the ratio of an area that is not peeled is used as a bonding rate. The bonding rate is preferably 90% or more.

The heatsink-integrated insulating circuit board 10 is heated under a condition of 290°C $\times$ 10 min, the bonding surface between the surface of the metal piece 33 and the surface of the heat sink 20, and the insulating resin layer 12 is evaluated using SAT, and the ratio of an area that is not peeled is used as a bonding rate. The bonding rate after heating is preferably 90% or more.

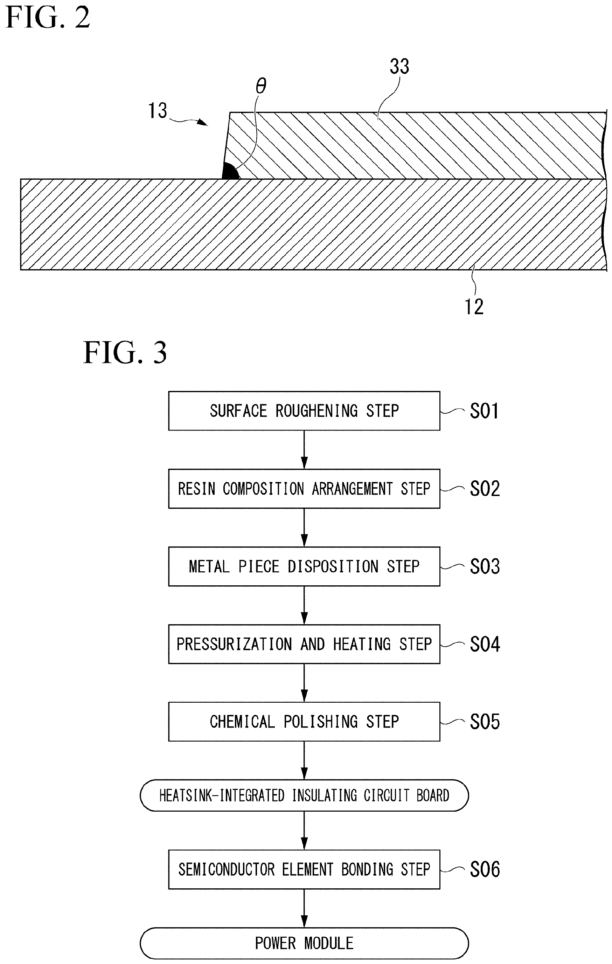

In the cross section along a laminating direction, as represented in FIG. 2, regarding the end surface shape of the circuit layer 13 (metal piece 33) in the vicinity of a bonding interface to the insulating resin layer 12, an angle $\theta$ formed between the surface of the insulating resin layer 12 and the end surface of the circuit layer 13 (metal piece 33) at the end of the circuit pattern is set to be in the range of 70° or more and 110° or less.

The lower limit of the angle $\theta$ is further preferably 80° or more, and more preferably 85° or more. On the other hand, the upper limit of the angle $\theta$ is further preferably 100° or less, and more preferably 95° or less.

The angle $\theta$ can be measured, for example, by a method as follows.

(Method for Measuring Angle $\theta$)

Using a cross-section polisher (SM-09010 manufactured by JEOL Ltd.), the cross-section of the circuit layer is ion-etched under conditions of an ion acceleration voltage of 5 kV, the processing time of 14 hours, and the protrusion amount from a shielding plate of 100 $\mu$m. Then, the end of the circuit pattern is observed using an electron scanning microscope (SEM), and the angle $\theta$ (end angle 0) formed between the end of the circuit layer (metal piece) and the surface of the insulating resin layer is measured.

Here, in the heatsink-integrated insulating circuit board 10 in the present embodiment, when the root-mean-square height of a contour curved surface in the bonding surface of the top plate part 21 of the heat sink 20 to the insulating resin layer 12 and the bonding surface of the circuit layer 13 to the insulating resin layer 12 is set as Sq1, the root-mean-square height of a contour curved surface in a region of the top plate part 21 of the heat sink 20 other than the bonding surface to the insulating resin layer 12 and a region of the circuit layer 13 other than the bonding surface to the insulating resin layer 12 is set as Sq2, the root-mean-square height of a contour curve in the bonding surface of the top plate part 21 of the heat sink 20 to the insulating resin layer 12 and the bonding surface of the circuit layer 13 to the insulating resin layer 12 is set as Rq1, and the root-mean-square height of a contour curve in the region of the top plate part 21 of the heat sink 20 other than the bonding surface to the insulating resin layer 12 and the region of the circuit layer 13 other than the bonding surface to the insulating resin layer 12 is set as Rq2, $Sq1 > Sq2$ or $Rq1 > Rq2$ is set to be satisfied.

That is, the surface roughness of the bonding surface between the circuit layer 13 and the top plate part 21 of the heat sink 20, and the insulating resin layer 12 is rougher than the surface roughness of the region other than the bonding surface.

In the present embodiment, it is assumed that the root-mean-square height Sq1 of the contour curved surface in the bonding surface of the top plate part 21 of the heat sink 20 to the insulating resin layer 12 and the bonding surface of the circuit layer 13 to the insulating resin layer 12, and the root-mean-square height Rq1 of the contour curve in the bonding surface of the top plate part 21 of the heat sink 20 to the insulating resin layer 12 and the bonding surface of the circuit layer 13 to the insulating resin layer 12 show the equivalent numerical values.

In addition, it is assumed that the root-mean-square height Sq2 of the contour curved surface in the region of the top plate part 21 of the heat sink 20 other than the bonding surface to the insulating resin layer 12 and the region of the circuit layer 13 other than the bonding surface to the insulating resin layer 12, and the root-mean-square height Rq2 of the contour curve in the region of the top plate part 21 of the heat sink 20 other than the bonding surface to the insulating resin layer 12 and the region of the circuit layer 13 other than the bonding surface to the insulating resin layer 12 show the equivalent numerical values.

Further, in the present embodiment, the ratio Sq1/Sq2 between the root-mean-square height Sq1 of the contour curved surface in the above-described bonding surface and the root-mean-square height Sq2 of the contour curved surface in the region other than the above-described bonding surface, or the ratio Rq1/Rq2 between the root-mean-square height Rq1 of the contour curve in the above-described bonding surface and the root-mean-square height Rq2 of the contour curve in the region other than the above-described bonding surface is preferably set to be in the range of 1.1 or more and 5.0 or less, more preferably in a range of 1.5 or more and 4.0 or less, and further preferably in a range of 2.0 or more and 3.0 or less.

Sq1/Sq2 or Rq1/Rq2 is more preferably 1.5 or more, and further preferably 2.0 or more. Also, Sq1/Sq2 or Rq1/Rq2 is more preferably 4.0 or less, and further preferably 3.0 or less.

Furthermore, in the present embodiment, the root-mean-square height Sq1 of the contour curved surface in the bonding surface of the top plate part 21 of the heat sink 20 to the insulating resin layer 12 and the bonding surface of the circuit layer 13 to the insulating resin layer 12, of the root-mean-square height Rq1 of the contour curve in the bonding surface of the top plate part 21 of the heat sink 20 to the insulating resin layer 12 and the bonding surface of the circuit layer 13 to the insulating resin layer 12 is preferably in a range of 0.45 $\mu$m or more and 1.0 $\mu$m or less, more preferably in a range of 0.5 $\mu$m or more and 0.9 $\mu$m or less, and further preferably in a range of 0.6 $\mu$m or more and 0.8 $\mu$m or less.

The root-mean-square height Sq1 or Rq1 in the above-described bonding surface is more preferably 0.5 $\mu$m or more, and further preferably 0.6 $\mu$m or more. Further, the root-mean-square height Sq1 or Rq1 in the above-described bonding surface is more preferably 0.9 $\mu$m or less, and further preferably 0.8 $\mu$m or less.

In addition, in the present embodiment, the root-mean-square height Sq2 of the contour curved surface in the region of the top plate part 21 of the heat sink 20 other than the bonding surface to the insulating resin layer 12 and the region of the circuit layer 13 other than the bonding surface to the insulating resin layer 12, or the root-mean-square height Rq2 of the contour curve in the region of the top plate part 21 of the heat sink 20 other than the bonding surface to the insulating resin layer 12 and the region of the circuit layer 13 other than the bonding surface to the insulating resin layer 12 is preferably in a range of 0.1 $\mu$m or more and 0.4 $\mu$m or less.

The root-mean-square height Sq2 or Rq2 in the region other than the above-described bonding surface is more preferably 0.15 $\mu$m or more, and further preferably 0.20 $\mu$m or more. Further, the root-mean-square height Sq2 or Rq2 in the region other than the above-described bonding surface is more preferably 0.35 $\mu$m or less, and further preferably 0.30 $\mu$m or less.

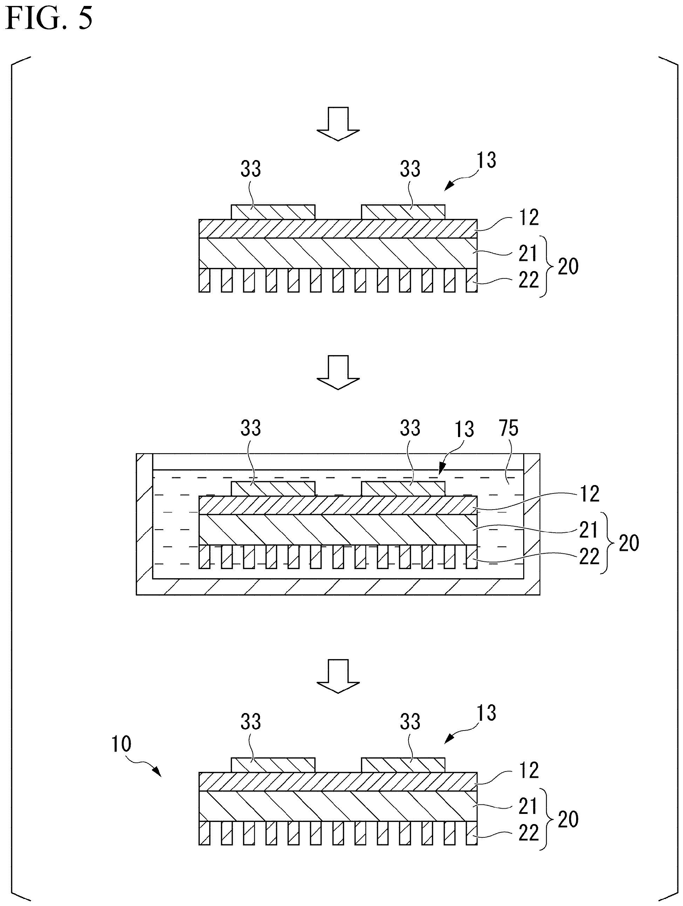

A method for manufacturing the heatsink-integrated insulating circuit board 10 in the present embodiment will be described below with reference to FIGS. 3 to 5.

(Surface Roughening Step S01)

First, the surfaces of the metal piece 33 as the circuit layer 13 and the heat sink 20 are roughened. In the present embodiment, the root-mean-square height of the contour curved surface and the root-mean-square height of the contour curve in the surface after the surface roughening step S01 is preferably set to be in the range of 0.45 $\mu$m or more and 1.0 $\mu$m or less.

Specifically, a roughened plating layer is formed on the surface of the metal piece 33 as the circuit layer 13 and the surface of the heat sink 20. As a result, an uneven portion is formed on each of the surfaces of the metal piece 33 as the circuit layer 13 and the heat sink 20. In addition, the roughened plating layer is formed as follows.

Electrolytic plating is performed on the surfaces of the metal piece 33 and the heat sink 20. In the present embodiment, as an electrolytic plating solution, an electrolytic solution made of an aqueous solution obtained by adding 3,3'-dithiobis(1-propanesulfonic acid)disodium to a copper sulfate bath containing copper sulfate ($CuSO_4$) and sulfuric acid ($H_2SO_4$) as main components is preferably used. Also, the temperature of the plating bath is preferably set to be in a range of 25°C or higher and 35°C or lower, for example.

A periodic reverse (PR) pulse electrolysis method is used as the electrolytic plating. The PR pulse electrolysis method is a method of performing electroplating by energizing while periodically reversing the direction of the current. For example, positive electrolysis of 5 A/dm² or more and 30 A/dm² or less (anodic electrolysis using the metal piece 33 and the heat sink 20 as anodes) for 1 ms or more and 1000 ms or less, and negative electrolysis of 1 A/dm² or more and 20 A/dm² or less (negative electrolysis using the metal piece 33 and the heat sink 20 as cathodes) for 1 ms or more and 1000 ms or less are repeated. As a result, the dissolution of the surfaces of the metal piece 33 and the heat sink 20 and the deposition of copper are repeated to form the roughened plating layer.

(Resin Composition Arrangement Step S02)

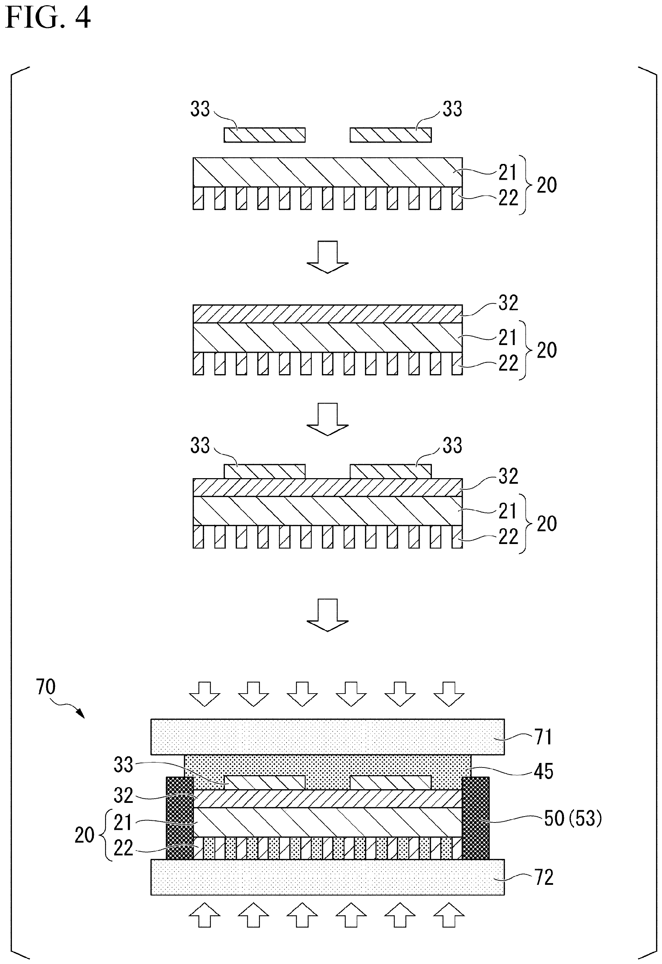

Then, as represented in FIG. 4, a resin composition 32 containing a filler of an inorganic material, a resin, and a curing agent is arranged on one surface (upper surface in FIG. 4) of the top plate part 21 of the heat sink 20. In the present embodiment, the resin composition 32 is in a form of a sheet.

(Metal Piece Disposition Step S03)

Then, as represented in FIG. 4, a plurality of metal pieces 33 serving as the circuit layer 13 are disposed in a circuit pattern on one surface (upper surface in FIG. 4) of the resin composition 32.

(Pressurization and Heating Step S04)

Then, as represented in FIG. 4, the heat sink 20, the resin composition 32, and the metal piece 33 are disposed between an upper pressing plate 71 and a lower pressing plate 72 of a pressurizing device 70, and are pressurized and heated in the laminating direction. In this manner, the resin composition 32 is cured to form the insulating resin layer 12 and bond the top plate part 21 of the heat sink 20 and the insulating resin layer 12 to each other and bond the insulating resin layer 12 and the metal piece 33 to each other.

In the present embodiment, in the pressurization and heating step S04, as represented in FIG. 4, a cushion material 45 is disposed on the metal piece 33 side (upper pressing plate 71 side), a receiving jig 50 including a guide wall part 53 facing the peripheral edge part of the cushion material 45 is disposed on the heat sink 20 side (lower pressing plate 72), and the metal piece 33, the resin composition 32, and the heat sink 20 are pressurized in the laminating direction by the upper pressing plate 71 and the lower pressing plate 72. In pressurization, the peripheral edge part of the cushion material 45 and the guide wall part 53 of the receiving jig 50 come into contact with each other, so that an occurrence of a situation in which the peripheral edge part of the cushion material 45 protrudes outward is prevented.

In the present embodiment, as represented in FIG. 4, the cushion material 45 is also arranged on the radiating fins 22 of the heat sink 20.

Here, it is preferable that the cushion material 45 be set to have hardness H1 in a range of 10° or more and 75° or less. In the present embodiment, it is assumed that, for example, the cushion material is made of silicone rubber or the like. It is assumed that the hardness of the cushion material is measured in accordance with JIS K 7312 by using an Asker rubber hardness tester C type (manufactured by Kobunshi Keiki Co., Ltd.).

In addition, it is preferable that the receiving jig 50 (the guide wall part 53) be set to have hardness H2 in a range of 50 or more and 1000 or less. In the present embodiment, it is assumed that, for example, the receiving jig 50 is made of an aluminum alloy, carbon, or the like. It is assumed that the hardness of the receiving jig is measured in accordance with JIS Z 2244:2009 Vickers hardness test.

Furthermore, in the pressurization and heating step S04, it is preferable that a heating temperature is set within a range of 120°C or higher and 350°C or lower, and a holding time at the heating temperature is set within a range of 10 minutes or longer and 180 minutes or shorter. Further, it is preferable that the pressurizing load in the laminating direction is set within a range of 1 MPa or more and 30 MPa or less.

Here, the lower limit of the heating temperature is more preferably set to 150°C or higher, and more preferably 170°C or higher. On the other hand, the upper limit of the heating temperature is more preferably set to 320°C or lower, and more preferably 300°C or lower.

The lower limit of the holding time at the heating temperature is more preferably set to 30 minutes or longer, and more preferably 60 minutes or longer. On the other hand, the upper limit of the holding time at the heating temperature is more preferably set to 120 minutes or shorter, and more preferably 90 minutes or shorter.

The lower limit of the pressurizing load in the laminating direction is more preferably set to 3 MPa or more, and more preferably set to 5 MPa or more. On the other hand, the upper limit of the pressurizing load in the laminating direction is more preferably set to 15 MPa or less, and more preferably set to 10 MPa or less.

(Chemical Polishing Step S05)

After the pressurization and heating step S04, chemical polishing is performed to smoothen the surface of a region of the top plate part 21 of the heat sink 20 other than the bonding surface to the insulating resin layer 12 and the surface of a region of the circuit layer 13 other than the bonding surface to the insulating resin layer 12. In the present embodiment, the root-mean-square height of a contour curved surface and the root-mean-square height of a contour curve in the surface of the region of the top plate part 21 of the heat sink 20 other than the bonding surface to the insulating resin layer 12 and the surface of the region of the circuit layer 13 other than the bonding surface to the insulating resin layer 12, after the chemical polishing step S05, are preferably set to be in a range of 0.1 $\mu$m or more and 0.4 $\mu$m or less.

As a chemical polishing liquid 75 used in the chemical polishing step S05, for example, an aqueous solution containing sulfuric acid and hydrogen peroxide can be used.

With each step described above, the heatsink-integrated insulating circuit board 10 according to the present embodiment is manufactured.

(Semiconductor Element-Bonding Step S06)

Then, the semiconductor element 3 is bonded to the circuit layer 13 of the heatsink-integrated insulating circuit board 10. In the present embodiment, the circuit layer 13 and the semiconductor element 3 are bonded to each other via a solder material. With the steps described above, the power module 1 represented in FIG. 1 is manufactured.

According to the heatsink-integrated insulating circuit board 10 according to the present embodiment configured as described above, the angle $\theta$ formed between the end of the circuit layer 13 (metal piece 33) and the surface of the insulating resin layer 12 is set to be in the range of 70° or more and 110° or less, and thus sagging does not occur on the end surface of the circuit layer 13 (metal piece 33), it is possible to suppress electric field concentration on the end surface of the circuit layer 13 (metal piece 33), and the insulating property is excellent.

The root-mean-square height Sq1 of the contour curved surface in the bonding surface of the top plate part 21 of the heat sink 20 to the insulating resin layer 12 and the bonding surface of the circuit layer 13 (metal piece 33) to the insulating resin layer 12 is set to be less than the root-mean-square height Sq2 of the contour curved surface in the region of the top plate part 21 of the heat sink 20 other than the bonding surface to the insulating resin layer 12 and the region of the circuit layer 13 (metal piece 33) other than the bonding surface to the insulating resin layer 12, or the root-mean-square height Rq1 of the contour curve in the bonding surface of the top plate part 21 of the heat sink 20 to the insulating resin layer 12 and the bonding surface of the circuit layer 13 (metal piece 33) to the insulating resin layer 12 is set to be less than the root-mean-square height Rq2 of the contour curve in the region of the top plate part 21 of the heat sink 20 other than the bonding surface to the insulating resin layer 12 and the region of the circuit layer 13 (metal piece 33) other than the bonding surface to the insulating resin layer 12. Thus, the bonding reliability between the circuit layer 13 (metal piece 33) and the insulating resin layer 12 and between the insulating resin layer 12 and the top plate part 21 of the heat sink 20 is excellent, the surface other than the bonding surface is not rough, and platability, solderability, and wire-bondability are excellent.

In the present embodiment, when the ratio Sq1/Sq2 between the root-mean-square height Sq1 of the contour curved surface in the bonding surface and the root-mean-square height Sq2 of the contour curved surface in the region other than the bonding surface, or the ratio Rq1/Rq2 between the root-mean-square height Rq1 of the contour curve in the bonding surface and the root-mean-square height Rq2 of the contour curve in the region other than the bonding surface is set to be 1.1 or more, the root-mean-square height Sq1 in the bonding surface of the top plate part 21 of the heat sink 20 and the circuit layer 13 (metal piece 33) to the insulating resin layer 12 or the root-mean-square height Rq1 of the contour curve in the bonding surface is sufficiently large. Thus, the bonding reliability between the circuit layer 13 (metal piece 33) and the insulating resin layer 12 and the bonding reliability between the insulating resin layer 12 and the top plate part 21 of the heat sink 20 are particularly excellent. In addition, the root-mean-square height Sq2 in the region of the top plate part 21 of the heat sink 20 and the circuit layer 13 (metal piece 33) other than the bonding surface to the insulating resin layer 12 or the root-mean-square height Rq2 of the contour curve in the region other than the bonding surface is sufficiently small, and thus the platability, the solderability, and the wire-bondability are particularly excellent.

Also, when the ratio Sq1/Sq2 between the root-mean-square height Sq1 of the contour curved surface in the bonding surface and the root-mean-square height $Sq2$ of the contour curved surface in the region other than the bonding surface, or the ratio $Rq1/Rq2$ between the root-mean-square height $Rq1$ of the contour curve in the bonding surface and the root-mean-square height $Rq2$ of the contour curve in the region other than the bonding surface is set to be 5.0 or less, the root-mean-square height $Sq1$ of the contour curved surface in the bonding surface is not largely different from the root-mean-square height $Sq2$ of the contour curved surface in the region other than the bonding surface, or the root-mean-square height $Rq1$ of the contour curve in the bonding surface is not largely different from the root-mean-square height $Rq2$ of the contour curve in the region other than the bonding surface. Thus, it is not necessary to perform the surface roughening step S01 and the chemical polishing step S05 under conditions that are unnecessarily high, and it is possible to stably manufacture the heatsink-integrated insulating circuit board 10 at relatively low cost.

In the present embodiment, when the root-mean-square height $Sq1$ of the contour curved surface in the bonding surface of the top plate part 21 of the heat sink 20 and the circuit layer 13 (metal piece 33) to the insulating resin layer 12 or the root-mean-square height $Rq1$ of the contour curve in the bonding surface is set to be in the range of 0.45 $\mu$m or more and 1.0 $\mu$m or less, the root-mean-square height $Sq1$ of the contour curved surface in the bonding surface or the root-mean-square height $Rq1$ of the contour curve in the bonding surface is sufficiently large. Thus, the bonding reliability between the circuit layer 13 (metal piece 33) and the insulating resin layer 12 and between the insulating resin layer 12 and the top plate part 21 of the heat sink 20 is excellent.

In the present embodiment, when the root-mean-square height $Sq2$ of the contour curved surface in the region of the top plate part 21 of the heat sink 20 and the circuit layer 13 (metal piece 33) other than the bonding surface to the insulating resin layer 12 or the root-mean-square height $Rq2$ of the contour curve in the region other than the bonding surface is set to be in the range of 0.1 $\mu$m or more and 0.4 $\mu$m or less, the root-mean-square height $Sq2$ of the contour curved surface in the region of the top plate part 21 of the heat sink 20 and the circuit layer 13 (metal piece 33) other than the bonding surface to the insulating resin layer 12 or the root-mean-square height $Rq2$ of the contour curve in the region other than the bonding surface is sufficiently small. Thus, the platability, the solderability, and the wire-bondability are excellent.

According to the method for manufacturing the heatsink-integrated insulating circuit board 10 according to the present embodiment, the surface roughening step S01 of roughening the surface of the heat sink 20 and the surface of the metal piece 33 is performed, and then, the resin composition arrangement step S02, the metal piece disposition step S03, and the pressurization and heating step S04 are performed. Thus, the root-mean-square height $Sq1$ of the contour curved surface in the bonding surface of the circuit layer 13 (metal piece 33) and the top plate part 21 of the heat sink 20 to the insulating resin layer 12 or the root-mean-square height $Rq1$ of the contour curve is sufficiently large. Thus, it is possible to manufacture the heatsink-integrated insulating circuit board 10 having excellent bonding reliability between the circuit layer 13 (metal piece 33) and the top plate part 21 of the heat sink 20, and the insulating resin layer 12.

Since the chemical polishing step S05 of chemically polishing the surfaces of the heat sink 20 and the circuit layer 13 is provided after the pressurization and heating step S04, the root-mean-square height $Sq2$ of the contour curved surface or the root-mean-square height $Rq2$ of the contour curve in the region of the circuit layer 13 and the top plate part 21 of the heat sink 20 other than the bonding surface to the insulating resin layer 12 is sufficiently small, and it is possible to manufacture the heatsink-integrated insulating circuit board 10 that is excellent in platability, solderability, and wire-bondability.

In addition, it is possible to form the circuit pattern without performing etching, to form the end surface shape of the circuit layer 13 with high accuracy, and to suppress the electric field concentration at the end of the bonding interface of the circuit layer 13. Thus, it is possible to manufacture the heatsink-integrated insulating circuit board 10 having the excellent insulating property.

Although the embodiment of the present invention has been described above, the present invention is not limited to the above description, and can be appropriately changed without departing from the technical idea of the invention.

For example, in the present embodiment, a case where the power module is configured by mounting a power semiconductor element on the circuit layer of the heatsink-integrated insulating circuit board has been described, but the present embodiment is not limited to this. For example, an LED element may be mounted on the heatsink-integrated insulating circuit board to form an LED module, or a thermoelectric element may be mounted on the circuit layer of the heatsink-integrated insulating circuit board to form a thermoelectric module.

Furthermore, in the present embodiment, a case where the rough surface plating layer is formed in the surface roughening step has been described, but the present embodiment is not limited to this, and the surface roughening step may be performed by other means.

[Examples]

The results of the confirmation experiment conducted to confirm the effect of the present invention will be described below.

A heat sink (made of oxygen-free copper (OFC), top plate part thickness: 3.0 mm) having radiating fins and a metal piece (see Table 1 for material and thickness) forming a circuit layer were prepared.

Here, in Examples 1 to 12 of the present invention and Comparative Example 2, the surfaces of the heat sink and the metal piece were subjected to surface roughening by means described in the section of the embodiment of the invention.

Then, a sheet material of a resin composition shown in Table 1 was disposed on the top plate part of the heat sink, and a metal piece forming the circuit layer shown in Table 1 was disposed on the sheet material of the resin composition. The heat sink, the sheet material of the resin composition, and the metal piece, which had been laminated, were heated while being pressurized in the laminating direction to cure the resin composition and thus to form the insulating resin layer and bond the top plate part of the heat sink and the insulating resin layer to each other and bond the insulating resin layer and the metal piece to each other. In this manner, a heatsink-integrated insulating circuit board was obtained. When the sheet material was polyimide, the pressurizing pressure in the laminating direction was set to 5 MPa, the heating temperature was set to 300°C, and the holding time at the heating temperature was set to 60 minutes. When the sheet material was epoxy, the pressurizing pressure in the laminating direction was set to 10 MPa, the heating temperature was set to 200°C, and the holding time at the heating temperature was set to 60 minutes.

Then, in Examples 1 to 12 of the present invention, chemical polishing was performed by immersion in a chemical polishing liquid. As the chemical polishing liquid, a liquid composed of 100 g/L of sulfuric acid, 30 g/L of hydrogen peroxide, and the balance of deionized water was used.

In Comparative Example 3, the surface roughening and the chemical polishing were not performed, a metal plate was bonded instead of the metal piece, and then a circuit pattern was formed by performing etching.

As described above, the obtained heatsink-integrated insulating circuit board was evaluated for the following items.

(Angle θ Formed between End of Circuit Layer (Metal Piece) and Surface of Insulating Resin Layer)

Using a cross-section polisher (SM-09010 manufactured by JEOL Ltd.), the cross-section of the circuit layer was ion-etched at an ion acceleration voltage of 5 kV, the processing time of 14 hours, and protrusion amount of 100 $\mu$m from the shielding plate. Then, the end of the circuit pattern was observed using an electron scanning microscope (SEM). The angle θ (end angle 0) formed between the end of the circuit layer (metal piece) and the surface of the insulating resin layer was measured.

(Surface Roughness)

The surface roughness of the metal piece and the heat sink after the surface roughening and the surface roughness of the metal piece and the heat sink after the chemical polishing were measured.

Using a laser microscope LEXT OLS5000 manufactured by Olympus, the surface roughness was measured at a magnification of 100 times. Ten measurement points were randomly selected as measurement points, and evaluation was performed by using the mean value of the root-mean-square height Sq at the ten points, as an index as a roughness parameter.

The root-mean-square height of the surfaces of the metal piece and the heat sink after the surface roughening is the root-mean-square height $Sq1$ in the bonding surface to the insulating resin layer. Further, the root-mean-square height of the surfaces of the metal piece and the heat sink after the chemical polishing is the root-mean-square height $Sq2$ in the region other than the bonding surface to the insulating resin layer.

In addition, the root-mean-square height Rq of the contour curved surface was calculated with respect to the direction in which the roughness is considered to be the roughest in the measurement view field obtained by the surface roughness measurement described above. At least three points or more were measured in a measurement range.

The root-mean-square height of the surfaces of the metal piece and the heat sink after the surface roughening is the root-mean-square height $Rq1$ in the bonding surface to the insulating resin layer. Further, the root-mean-square height of the surfaces of the metal piece and the heat sink after the chemical polishing is the root-mean-square height $Rq2$ in the region other than the bonding surface to the insulating resin layer.

(Rq acquisition in Bonding Surface from Cross-sectional Observation)

The root-mean-square height Rq of the bonding surface between the surface of the metal piece and the surface of the heat sink, and the insulating resin layer can also be obtained from the cross-sectional observation of the bonding surface.

Using a cross-section polisher (SM-09010 manufactured by JEOL Ltd.), the cross-section of the bonding surface between the surface of the metal piece and the surface of the heat sink, and the insulating resin layer was ion-etched at the ion acceleration voltage: 5 kV, the processing time: 14 hours, and the protrusion amount of 100 $\mu$m from a shielding plate. Then, a bonding interface is observed with a laser microscope (field size: 100 $\mu$m × 70 $\mu$m). Then, the root-mean-square height Rq of the contour curved surface at the bonding interface can be calculated from the following expression.

$$Rq = \sqrt{\frac{1}{\ell} \int_0^{\ell} Z^2(x)\, dx}$$

R: reference length (width in the observation visual field)
z (x): function of contest curve

(Dielectric Breakdown Voltage)

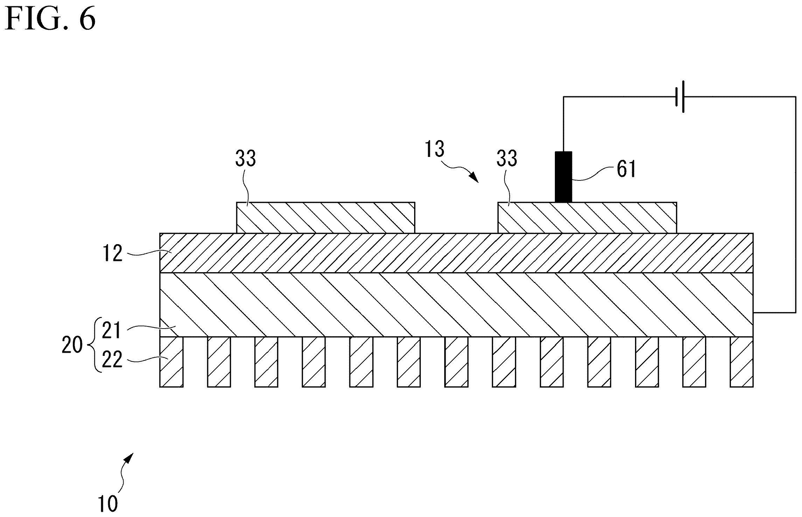

As represented in FIG. 6, a probe 61 was brought into contact with the circuit layer 13 to evaluate partial discharge. A partial discharge tester manufactured by Mitsubishi Cable Co., Ltd. was used as a measurement device. The test atmosphere was Fluorinert (tm) FC-770 manufactured by 3M.
Then, the voltage was increased with a step profile (holding time: 60 seconds) every 0.5 kV, and the voltage at which dielectric breakdown occurred (the voltage at which a leakage current became 10 mA or more) was taken as the dielectric breakdown voltage.

(Bonding Reliability)

The obtained heatsink-integrated insulating circuit board was heated at 290°C for 10 minutes, and the bonding state after that was evaluated using SAT (ultrasound imaging device, Fine SAT V manufactured by Hitachi Power Solutions).
The bonding rate was defined as the ratio of the area that is not peeled in the bonding surface in the measurement by SAT. A case where the bonding rate after the heating is 90% or more was evaluated to be "A", and a case of less than 90% was evaluated to be "B".

(Solder Bondability)

A Si element (5SLY86E1200 manufactured by ABB, 6 mm square) was solder-bonded to the surface of the circuit layer of the obtained heatsink-integrated insulating circuit board by using a solder sheet (M725 manufactured by Senju Metal Industry Co., Ltd., 8 mm square, thickness 0.10 mm).
The bonding state between the circuit layer and the Si element was evaluated by using SAT (ultrasound imaging device, Fine SAT V manufactured by Hitachi Power Solutions).
The bonding rate was defined as the ratio of the area that is not peeled in the bonding surface in the measurement by SAT. A case where the bonding rate is 90% or more was evaluated to be "A", and a case of less than 90% was evaluated to be "B".

[Table 1]

|  | Resin Composition (Insulating resin layer) | | | | Circuit layer (metal piece) | | |
|---|---|---|---|---|---|---|---|
|  | Thermosetting resin | Inorganic filler | Thickness (mm) | Thermal conductivity W/(m·K) | Material | Thickness (mm) | End angle θ (°) |
| Example 1 | Epoxy | $Al_2O_3$, BN | 0.15 | 15 | OFC | 0.3 | 87 |
| Example 2 | Epoxy | $Al_2O_3$, BN | 0.15 | 15 | OFC | 0.5 | 93 |
| Example 3 | Epoxy | $Al_2O_3$, BN | 0.15 | 15 | OFC | 1.0 | 86 |
| Example 4 | Epoxy | $Al_2O_3$, BN | 0.15 | 15 | OFC | 1.5 | 85 |
| Example 5 | Epoxy | $Al_2O_3$, BN | 0.15 | 15 | OFC | 1.0 | 81 |
| Example 6 | Epoxy | $Al_2O_3$, BN | 0.15 | 15 | OFC | 1.0 | 73 |
| Example 7 | Epoxy | $Al_2O_3$, BN | 0.15 | 15 | OFC | 1.0 | 108 |

EP 4 254 486 A1

(continued)

| | Resin Composition (Insulating resin layer) | | | | Circuit layer (metal piece) | | |
|---|---|---|---|---|---|---|---|
| | Thermosetting resin | Inorganic filler | Thickness (mm) | Thermal conductivity W/(m·K) | Material | Thickness (mm) | End angle θ (°) |
| Example 8 | Epoxy | $Al_2O_3$, BN | 0.15 | 15 | OFC | 1.0 | 78 |
| Example 9 | Epoxy | $Al_2O_3$, BN | 0.15 | 15 | OFC | 1.0 | 83 |
| Example 10 | Epoxy | $Al_2O_3$, BN | 0.15 | 15 | OFC | 1.0 | 101 |
| Example 11 | Epoxy | $Al_2O_3$, BN | 0.15 | 15 | OFC | 1.0 | 96 |
| Example 12 | Polyimide | BN | 0.05 | 0.8 | OFC | 1.0 | 85 |
| Comparative Example 1 | Epoxy | $Al_2O_3$, BN | 0.15 | 15 | OFC | 1.0 | 95 |
| Comparative Example 2 | Epoxy | $Al_2O_3$, BN | 0.15 | 15 | OFC | 1.0 | 82 |
| Comparative Example 3 | Epoxy | $Al_2O_3$, BN | 0.15 | 15 | OFC | 1.0 | 44 |

[Table 2]

| | Manufacturing step | | Root-mean-square height | | | Evaluation | | |
|---|---|---|---|---|---|---|---|---|
| | Surface roughness | Chemical polishing | Sq1 (μm) | Sq2 (μm) | Sq1/Sq2 | Dielectric breakdown voltage (kV/mm) | Bonding reliability | Solder bondability |
| Example 1 | Provided | Provided | 0.72 | 0.33 | 2.18 | 55.7 | A | A |
| Example 2 | Provided | Provided | 0.88 | 0.18 | 4.89 | 53.7 | A | A |
| Example 3 | Provided | Provided | 0.83 | 0.35 | 2.37 | 57.2 | A | A |
| Example 4 | Provided | Provided | 0.55 | 0.28 | 1.96 | 54.5 | A | A |
| Example 5 | Provided | Provided | 0.66 | 0.38 | 1.74 | 53.8 | A | A |
| Example 6 | Provided | Provided | 0.61 | 0.31 | 1.97 | 56.3 | A | A |
| Example 7 | Provided | Provided | 0.59 | 0.23 | 2.57 | 55.2 | A | A |
| Example 8 | Provided | Provided | 0.51 | 0.34 | 1.50 | 61.3 | A | A |
| Example 9 | Provided | Provided | 0.71 | 0.26 | 2.73 | 52.6 | A | A |
| Example 10 | Provided | Provided | 0.91 | 0.35 | 2.60 | 54.2 | A | A |
| Example 11 | Provided | Provided | 0.46 | 0.39 | 1.18 | 53.8 | A | A |
| Example 12 | Provided | Provided | 0.64 | 0.31 | 2.06 | 53.8 | A | A |
| Comparative Example 1 | None | None | 0.44 | 0.44 | 1.00 | 53.6 | B | A |
| Comparative Example 2 | Provided | None | 0.79 | 0.79 | 1.00 | 54.8 | A | B |
| Comparative Example 3 | Etching | | 0.84 | 0.55 | 1.53 | 47.2 | A | A |

In Comparative Example 1, the surface of the metal piece and the surface of the heat sink were not roughened.

Thus, the root-mean-square height Sq1 in the bonding surface of the circuit layer and the heat sink to the insulating resin layer was 0.44 $\mu$m. The bonding reliability was "x".

In Comparative Example 2, since the chemical polishing was not performed after bonding, the root-mean-square height Sq2 in the region of the circuit layer and the heat sink other than the bonding surface to the insulating resin layer was 0.79 $\mu$m, and the solder bondability was "$\times$".

In Comparative Example 3, since the circuit pattern was formed by etching, the angle $\theta$ at the end of the circuit layer was 44°, the dielectric breakdown voltage was as low as 47.2 kV/mm, and the insulating property was insufficient.

On the other hand, in Examples 1 to 12 of the present invention, in which the surface of the metal piece and the surface of the heat sink were roughened and then bonded to the insulating resin layer, and then chemical polishing was performed, the root-mean-square height Sq1 in the bonding surface of the circuit layer and the heat sink to the insulating resin layer is higher than the root-mean-square height Sq2 in the region of the circuit layer and the heat sink other than the bonding surface to the insulating resin layer, and the bonding reliability and solder bondability were excellent.

In addition, since the metal pieces were arranged in the circuit pattern and bonded, the angle $\theta$ at the end of the circuit layer was in the range of 70° or more and 110° or less, the dielectric breakdown voltage was sufficiently high, and the insulating property was excellent.

From the above description, according to the example of the present invention, it was confirmed that it is possible to provide a heatsink-integrated insulating circuit board and a method for manufacturing the heatsink-integrated insulating circuit board in which the bonding reliability and the insulating property between the circuit layer and the heat sink, and the insulating resin layer are excellent, and it is possible to favorably perform soldering, wire-bonding, and plating on the circuit layer and the heat sink, and which can be stably manufactured at low cost. In the examples of the present invention and the comparative examples, it was confirmed that the values of Sq1 and Rq1 were substantially equal to each other, and the values of Sq2 and Rq2 were substantially equal to each other.

[Industrial Applicability]

According to the present invention, it is possible to provide a heatsink-integrated insulating circuit board and a method for manufacturing the heatsink-integrated insulating circuit board in which the bonding reliability and the insulating property between the circuit layer and the heat sink, and the insulating resin layer are excellent, and it is possible to favorably perform soldering, wire-bonding, and plating on the circuit layer and the heat sink, and which can be stably manufactured at low cost.

[Reference Signs List]

1: Power module
3: Semiconductor element
10: Heatsink-integrated insulating circuit board
12: Insulating resin layer
13: Circuit layer
20: Heat sink
21: Top plate part
22: Radiating fin
32: Resin composition
33: Metal piece

## Claims

1. A heatsink-integrated insulating circuit board comprising:

   a heat sink including a radiating fin;
   an insulating resin layer formed on a top plate part of the heat sink; and
   a circuit layer made of metal pieces arranged in a circuit pattern on one surface of the insulating resin layer,
   wherein an angle $\theta$ formed between an end of the metal piece and a surface of the insulating resin layer is in a range of 70° or more and 110° or less, and
   when a root-mean-square height of a contour curved surface in a bonding surface of the top plate part of the heat sink to the insulating resin layer and a bonding surface of the metal piece to the insulating resin layer is set as Sq1,

a root-mean-square height of a contour curved surface in a region of the top plate part of the heat sink other than the bonding surface to the insulating resin layer and a region of the metal piece other than the bonding surface to the insulating resin layer is set as Sq2,

a root-mean-square height of a contour curve in the bonding surface of the top plate part of the heat sink to the insulating resin layer and the bonding surface of the metal piece to the insulating resin layer is set as Rq1, and

a root-mean-square height of a contour curve in the region of the top plate part of the heat sink other than the bonding surface to the insulating resin layer and the region of the metal piece other than the bonding surface to the insulating resin layer is set as Rq2,

a relationship of Sq1 > Sq2 or Rq1 > Rq2 is satisfied.

2. The heatsink-integrated insulating circuit board according to Claim 1, wherein
a ratio Sq1/Sq2 between the root-mean-square height Sq1 of the contour curved surface in the bonding surface and the root-mean-square height Sq2 of the contour curved surface in the region other than the bonding surface, or a ratio Rq1/Rq2 between the root-mean-square height Rq1 of the contour curve in the bonding surface and the root-mean-square height Rq2 of the contour curve in the region other than the bonding surface is set to be in a range of 1.1 or more and 5.0 or less.

3. The heatsink-integrated insulating circuit board according to Claim 1 or 2, wherein
the root-mean-square height Sq1 of the contour curved surface in the bonding surface, or the root-mean-square height Rq1 of the contour curve in the bonding surface is set to be in a range of 0.45 $\mu$m or more and 1.0 $\mu$m or less.

4. The heatsink-integrated insulating circuit board according to any one of Claims 1 to 3, wherein
the root-mean-square height Sq2 of the contour curved surface in the region other than the bonding surface, or the root-mean-square height Rq2 of the contour curve in the region other than the bonding surface is set to be in a range of 0.1 $\mu$m or more and 0.4 $\mu$m or less.

5. A method for manufacturing a heatsink-integrated insulating circuit board including a heat sink including a radiating fin, an insulating resin layer formed on a top plate part of the heat sink, and a circuit layer made of metal pieces arranged in a circuit pattern on one surface of the insulating resin layer, the method comprising:

a surface roughening step of roughening a surface of the heat sink and a surface of the metal piece;
a resin composition arrangement step of arranging a resin composition made of a thermosetting resin on the top plate part of the heat sink subjected to the surface roughening step;
a metal piece disposition step of disposing the metal piece in a circuit pattern on the resin composition;
a pressurization and heating step of pressurizing and heating the heat sink, the resin composition, and the metal piece in at least a laminating direction to cure the resin composition and form the insulating resin layer and to bond the insulating resin layer and the metal piece to each other and bond the insulating resin layer and the heat sink to each other; and
a chemical polishing step of chemically polishing the surfaces of the heat sink and the metal piece after the pressurization and heating step.

EP 4 254 486 A1

# FIG. 1

## FIG. 2

## FIG. 3

```
SURFACE ROUGHENING STEP         ~ S01
              ↓
RESIN COMPOSITION ARRANGEMENT STEP  ~ S02
              ↓
METAL PIECE DISPOSITION STEP    ~ S03
              ↓
PRESSURIZATION AND HEATING STEP ~ S04
              ↓
CHEMICAL POLISHING STEP         ~ S05
              ↓
HEATSINK-INTEGRATED INSULATING CIRCUIT BOARD
              ↓
SEMICONDUCTOR ELEMENT BONDING STEP  ~ S06
              ↓
POWER MODULE
```

# FIG. 4

# FIG. 5

FIG. 6

**INTERNATIONAL SEARCH REPORT**

International application No.

**PCT/JP2021/043225**

| A. | CLASSIFICATION OF SUBJECT MATTER |
|---|---|

*H01L 23/36*(2006.01)i
FI:   H01L23/36 C

According to International Patent Classification (IPC) or to both national classification and IPC

| B. | FIELDS SEARCHED |
|---|---|

Minimum documentation searched (classification system followed by classification symbols)

H01L23/36

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

| C. | DOCUMENTS CONSIDERED TO BE RELEVANT |
|---|---|

| Category* | Citation of document, with indication, where appropriate, of the relevant passages | Relevant to claim No. |
|---|---|---|
| X | JP 2018-101768 A (TOYO INK SC HOLDINGS CO LTD) 28 June 2018 (2018-06-28) paragraphs [0014]-[0046], fig. 2-5 | 1 |
| Y | paragraphs [0014]-[0046], fig. 2-5 | 1-5 |
| Y | JP 2018-62704 A (JX NIPPON MINING & METALS CORP) 19 April 2018 (2018-04-19) paragraphs [0047]-[0103] | 2-4 |
| Y | JP 2020-163650 A (MITSUBISHI MATERIALS CORP) 08 October 2020 (2020-10-08) paragraphs [0018]-[0048] | 1-5 |
| Y | JP 2013-93540 A (DAINIPPON PRINTING CO LTD) 16 May 2013 (2013-05-16) paragraph [0101], fig. 2 | 1-5 |
| Y | WO 2018/180965 A1 (TOSHIBA KK) 04 October 2018 (2018-10-04) paragraph [0024] | 5 |
| Y | JP 2015-220341 A (MITSUBISHI ELECTRIC CORP) 07 December 2015 (2015-12-07) paragraphs [0013]-[0038], fig. 4 | 1-4 |

✓ Further documents are listed in the continuation of Box C.   ✓ See patent family annex.

| * | Special categories of cited documents: |
|---|---|
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **07 February 2022** | **15 February 2022** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

**INTERNATIONAL SEARCH REPORT**

| International application No. |
| --- |
| **PCT/JP2021/043225** |

**C.    DOCUMENTS CONSIDERED TO BE RELEVANT**

| Category* | Citation of document, with indication, where appropriate, of the relevant passages | Relevant to claim No. |
| --- | --- | --- |
| A | JP 2001-57406 A (MATSUSHITA ELECTRIC IND CO LTD) 27 February 2001 (2001-02-27) paragraphs [0016]-[0021], fig. 1 | 1-5 |
| A | WO 98/23137 A1 (JERSEY-FIELD LIMITED) 28 May 1998 (1998-05-28) column 10, line 1 to column 12, line 20 | 1-5 |
| A | JP 64-50592 A (SHINKO KAGAKU KOGYO KK) 27 February 1989 (1989-02-27) p. 3, upper left column, line 11 to p. 9, lower right column, line 17, fig. 3 | 1-5 |

Form PCT/ISA/210 (second sheet) (January 2015)

INTERNATIONAL SEARCH REPORT
Information on patent family members

International application No.

**PCT/JP2021/043225**

| Patent document cited in search report | | | Publication date (day/month/year) | Patent family member(s) | | | Publication date (day/month/year) |
|---|---|---|---|---|---|---|---|
| JP | 2018-101768 | A | 28 June 2018 | (Family: none) | | | |
| JP | 2018-62704 | A | 19 April 2018 | CN | 107018623 | A | |
| | | | | paragraphs [0053]-[0250] | | | |
| | | | | JP | 2018-62706 | A | |
| | | | | JP | 2018-76601 | A | |
| | | | | KR | 10-2017-0055004 | A | |
| JP | 2020-163650 | A | 08 October 2020 | (Family: none) | | | |
| JP | 2013-93540 | A | 16 May 2013 | US | 2014/00085830 | A1 | |
| | | | | paragraphs [0162]-[0165], fig. 2 | | | |
| | | | | WO | 2012/128360 | A1 | |
| | | | | CN | 103548135 | A | |
| WO | 2018/180965 | A1 | 04 October 2018 | US | 2019/0327831 | A1 | |
| | | | | paragraphs [0071]-[0072] | | | |
| | | | | EP | 3606299 | A1 | |
| | | | | CN | 110226363 | A | |
| JP | 2015-220341 | A | 07 December 2015 | US | 2015/0332982 | A1 | |
| | | | | paragraphs [0016]-[0041], fig. 4 | | | |
| | | | | DE | 102015208588 | A1 | |
| | | | | CN | 105101673 | A | |
| JP | 2001-57406 | A | 27 February 2001 | (Family: none) | | | |
| WO | 98/23137 | A1 | 28 May 1998 | (Family: none) | | | |
| JP | 64-50592 | A | 27 February 1989 | (Family: none) | | | |

Form PCT/ISA/210 (patent family annex) (January 2015)

EP 4 254 486 A1

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2020195064 A
- JP 2015207666 A
- JP H09135057 A